# EUROPÄISCHE PATENTSCHRIFT

(11) **EP 3 049 369 B1**
(45) Veröffentlichungstag und Bekanntmachung des Hinweises auf die Patenterteilung: **04.03.2020**
(21) Anmeldenummer: 14758333.0
(22) Anmeldetag: 27.08.2014
(51) Int. Cl.: C01B 33/035

(54) **VERFAHREN ZUR HERSTELLUNG VON POLYKRISTALLINEM SILICIUM**
PROCESS FOR PRODUCING POLYCRYSTALLINE SILICON
PROCÉDÉ POUR LA PRÉPARATION DE SILICIUM POLYCRISTALLIN

(30) Priorität: 23.09.2013 DE 102013219070
(43) Veröffentlichungstag der Anmeldung: 03.08.2016
(73) Patentinhaber: Wacker Chemie AG, 81737 München (DE)
(72) Erfinder: MÜLLER, Barbara, 84508 Burgkirchen (DE); HÄCKL, Walter, 84558 Kirchweidach (DE); STOIBER, Wolfgang, 84307 Eggenfelden (DE)
(74) Vertreter: Belz, Ferdinand
(86) Internationale Anmeldenummer: PCT/EP2014/068119
(87) Internationale Veröffentlichungsnummer: WO 2015/039841

(56) Entgegenhaltungen:
- EP-A1- 2 607 309
- EP-A2- 2 157 051
- WO-A1-2013/114858
- US-A1- 2011 250 366
- US-A1- 2012 237 678

## Beschreibung

Die Erfindung betrifft ein Verfahren zur Herstellung von polykristallinem Silicium.

Hochreines polykristallines Silicium (Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und GießVerfahren zur Produktion von Solarzellen für die Photovoltaik.

Polysilicium wird üblicherweise mittels des Siemens-Verfahrens hergestellt. Dabei wird ein Reaktionsgas umfassend eine oder mehrere Silicium enthaltende Komponenten und gegebenenfalls Wasserstoff in einen Reaktor umfassend durch direkten Stromdurchgang erhitzte Trägerkörper eingeleitet, wobei sich an den Trägerkörpern Silicium in fester Form abscheidet. Als Silicium enthaltende Komponenten werden bevorzugt Silan (SiH₄), Monochlorsilan (SiH₃Cl), Dichlorsilan (SiH₂Cl₂), Trichlorsilan (SiHCl₃), Siliciumtetrachlorid (SiCl₄) oder Mischungen der genannten Stoffe eingesetzt.

Das Siemens-Verfahren wird üblicherweise in einem Abscheidereaktor (auch "Siemens-Reaktor" genannt) durchgeführt. In der gebräuchlichsten Ausführungsform umfasst der Reaktor eine metallische Bodenplatte und eine kühlbare Glocke, die auf die Bodenplatte gesetzt ist, so dass ein Reaktionsraum im Inneren der Glocke entsteht. Die Bodenplatte ist mit einer oder mehreren Gaseinlassöffnungen und einer oder mehreren Abgasöffnungen für die abgehenden Reaktionsgase sowie mit Halterungen versehen, mit deren Hilfe die Trägerkörper im Reaktionsraum gehalten und mit elektrischen Strom versorgt werden. Jeder Trägerkörper besteht meistens aus zwei dünnen senkrecht stehenden Filamentstäben und einer waagerechten Brücke, die in der Regel benachbarte Stäbe an ihren freien Enden verbindet. Die Filamentstäbe stecken senkrecht in am Reaktorboden befindlichen Elektroden, über die der Anschluss an die Stromversorgung erfolgt.

Zur Abscheidung von Polysilicium werden ein Absperrventil für das in den Reaktor strömende Reaktionsgas, ein Gemisch aus Wasserstoff und einer der zuvor genannten siliciumhaltigen Komponenten, sowie ein Absperrventil für das aus dem Reaktor strömende Abgas geöffnet. Das Reaktionsgas strömt durch die Zuführöffnung in der Bodenplatte in den geschlossenen Abscheidereaktor. Dort erfolgt die Abscheidung des Siliciums auf den durch direkten Stromdurchgang erhitzten Dünnstäben. Das dabei im Reaktor entstehende, heiße Abgas verlässt den Reaktor durch eine Öffnung in der Bodenplatte und kann anschließend einer Aufbereitung, beispielsweise einer Kondensation unterzogen, oder einem Wäscher zugeführt werden.

An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet. Die entstanden polykristallinen Siliciumstabpaare werden dann üblicherweise auf Raumtemperatur abgekühlt.

Es werden U-förmige polykristalline Siliciumstäbe erhalten, die mehrere Meter hoch sein können und mehrere 1000 kg wiegen können.

Nach Abkühlung auf Raumtemperatur können die Siliciumstäbe aus dem Reaktor entnommen werden. Da das Siemens-Verfahren diskontinuierlich geführt wird, werden die Reaktoren hierzu abgestellt, die Abscheidezeit wird also unterbrochen. Dabei werden die Absperrventile für Reaktionsgas geschlossen und die Stromzufuhr unterbrochen. Den geöffneten Reaktoren kann das abgeschiedene polykristalline Silicium entnommen werden. Zur Öffnung der Reaktoren wird ein Reaktoroberteil entfernt, üblicherweise nach oben gehoben.

Aus wirtschaftlicher Sicht ist es vorteilhaft, die Demontageund Rüstzeiten so kurz wie möglich zu gestalten, um die Zeitspanne zur nachfolgenden Abscheidecharge möglichst kurz zu halten.

Es ist erforderlich, die polykristallinen Stabpaare in einem Stück (zwei Stäbe und eine Brücke) aus dem Reaktor auszubauen. Auch Vollernter, die alle Stabpaare gleichzeitig entnehmen können, sind bekannt, wie nachfolgend noch erläutert wird.

Bei einer unpräzisen Entnahme kann es dazu kommen, dass ein oder mehrere Stäbe oder Stabpaare abkippen und dabei oder bei dem Kontakt z.B. mit dem Hallenboden, mit der Bodenplatte des Reaktors, mit anderen Stäben oder Stabpaaren zerbrechen. Sind in dem Reaktor mehrere Stäbe enthalten, ist die Gefahr sehr hoch, dass dann alle Stäbe dieser Charge brechen und aufgrund des Bruchs und der möglichen Verunreinigungen für die Weiterverarbeitung unbrauchbar sind.

Nach dem Stabausbau ist es üblich, Glocke und Bodenplatte des Reaktors zu reinigen und den Reaktor mit neuen Elektroden und Dünnstäben für die nächste Abscheidungscharge zu versehen. Nach dem Verschließen der Glocke wird das Verfahren zur Abscheidung der nächsten Charge Polysilicium erneut wie zuvor beschrieben durchgeführt.

Das Öffnen des Reaktors und der Stabausbau sollten in einer Weise erfolgen, so dass eine oberflächliche Verunreinigung der Stäbe vermieden wird und die Stäbe möglichst nicht zerbrechen.

JP7029045B beschreibt eine Demontagewippe, die seitlich an den Reaktor heranfährt und die Stabpaare heraushebt. Dieses Verfahren erfordert die vollständige Demontage des Reaktors bis auf die Bodenplatte. Die Gefahr hierbei besteht darin, dass die Stabpaare nur an den Elektroden mit den Gabeln entnommen werden. Dabei kann ein Abkippen des Stabpaares in die falsche Richtung nicht ausgeschlossen werden. Ein unkontrolliert fallendes Stabpaar kann neben einer erheblichen Gefährdung des Personals durch Splitter auch den Verlust einer gesamten Charge darstellen, wenn dieses Stabpaar die im Reaktor verbliebenen, noch stehenden Stabpaare mitreißt.

US 20120237678 A1 offenbart eine Vorrichtung zum Ausbau von polykristallinen Siliciumstäben, umfassend einen Körper mit Außenwänden, der so dimensioniert ist, dass die Stäbe von den Außenwänden umschlossen werden, wobei jede Außenwand eine Tür beinhaltet, um Zugang zu wenigstens einem der Stäbe zu erlauben. In einer bevorzugten Ausführungsform sind die Innenwände mit einem Polymer ausgekleidet, um eine Kontamination der polykristallinen Siliciumstäbe zu verhindern.

US 20100043972 A1 offenbart eine weitere Vorrichtung zum Ausbau von polykristallinen Siliciumstäben, umfassend eine Wand mit einer Innenwand, einer Außenwand und einer Vielzahl von Verbindungen zwischen Innenwand und Außenwand, eine Lücke zwischen Innen- und Außenwand, ein Zugangsfenster in der Außenwand, eine Bodenplatte, und eine Vielzahl von Kontakten auf der Bodenplatte, wobei Innen- und Außenwand zylindrisch und konzentrisch sind, die Lücke so dimensioniert ist, um eine Vielzahl von auf den Kontakten der Bodenplatte befindlichen Siliciumstäben aufzunehmen, wobei das Zugangsfenster so gestaltet ist, dass Zugang zu den Siliciumstäben ermöglicht wird. Die Stäbe können über die Zugangsfenster entnommen werden.

Es besteht aber das Problem, dass Vorrichtungen dieser Art einen hohen Platzbedarf zwischen den Stabpaaren benötigen. Ein hoher Platzbedarf ist aber zum Erreichen einer hohen Wirtschaftlichkeit (Ermöglichung hoher Enddurchmesser) von Nachteil.

Nachteilig an den zuvor beschriebenen Vorrichtungen ist zudem, dass bei schief stehenden Stäben oder bei einer teilweise umgefallenen Charge, was nicht selten vorkommen kann, deren Einsatz unmöglich ist.

Dies gilt auch für das in DE 10 2009 027 830 B3 beanspruchte Verfahren zur Entnahme von polykristallinen Siliciumstäben aus einem Reaktor, dass dadurch gekennzeichnet ist, dass eine starre und automatisierte Führung mit einem Computer gestützten Erkennungsverfahren anhand von Kalibrierungspunkten über den geöffneten Reaktor gefahren wird und die Stabpaare mittels einer mechanischen oder pneumatischen Klemmvorrichtung gegriffen werden und diese anschließend in eine Transportvorrichtung ablegt werden.

JP 63296840 A offenbart eine Vorrichtung zum Ausbau von Siliciumstäben aus einem Abscheidereaktor, bei dem ein einzelnes Stabpaar mithilfe von Klammern fixiert wird und aus dem Reaktor seitlich herausgehoben wird. JP 2002210355 A offenbart ebenfalls eine Vorrichtung zum Ausbau von Siliciumstäben, umfassend einen in drei Dimensionen beweglichen Arm, an dessen Ende eine Klemmvorrichtung montiert ist, mit der die Siliciumstäbe aus dem Reaktor gehoben werden können.

Nachteilig bei diesen beiden Vorrichtungen ist die Tatsache, dass die Stäbe aus dem komplett geöffneten Reaktor nur von außen nach innen entnommen werden können. Ein gezielter Ausbau eines bestimmten Siliciumstabes z.B. aus einem inneren Stabkreis, was manchmal wünschenswert ist, ist mit der beschriebenen Vorrichtung nicht möglich.

Nachteilig ist weiterhin, dass dieses System manuell angesteuert werden muss und die manuelle Koordination dieses vielachsigen Systems sehr schwer ist. Dadurch erhält man keinen zeitlichen Vorteil gegenüber herkömmlichen Entnahmevorrichtungen. Ein weiterer Nachteil sind die einwirkenden starken Biegekräfte auf diese Konstruktion beim Herausheben der Stäbe. Beim Ausbauvorgang muss eine gewisse Abzugkraft aufgebracht werden, was beim Lösen der Stäbe zu einem Federn des Armes führt. Dieses Federn des Armes kann beim Ausbau dazu führen, dass benachbarte Stabpaare vom Ausbauwerkzeug berührt und umgestoßen werden. Der Hauptnachteil dieses Systems besteht jedoch darin, dass zum Ausbau alle Stäbe zumindest teilweise frei im Raum stehen müssen, um vom Greifarm gefasst zu werden. Bei einem Umfallen eines oder mehrerer Stäbe führt dies unweigerlich zu Kontaminationen des Siliciums und kann sogar schwere Verletzungen der Mitarbeiter hervorrufen.

US 20120175613 A1 offenbart ein Verfahren zur Herstellung eines polykristallinen Siliciumstücks, bestehend aus einem CVD-Prozess zur Herstellung eines polykristallinen Siliciumstabs durch Abscheidung von Silicium auf einem Filamentdraht, dessen eines Ende an einer ersten Elektrode und dessen anderes Ende an einer zweiten Elektrode angeschlossen ist, einem Prozess zur Entnahme des polykristallinen Siliciumstabs aus dem Reaktor sowie einem Zerkleinerungsprozess des Siliciumstabs in Siliciumstücke, dadurch gekennzeichnet, dass vor dem Zerkleinerungsprozess mindestens 70 mm ab dem Elektrodenende vom polykristallinen Siliciumstab entfernt werden (Fußkürzungsprozess). In einer bevorzugten Ausführungsform wird die Oberfläche des polykristallinen Siliciumstabs vor der Entnahme aus dem Reaktor mit einem sackartigen Teil aus Polyethylen überzogen. Die Entnahme selbst kann mittels eines Krans oder dergleichen erfolgen.

Die im Stand der Technik gezeigte Vorgehensweise und verwendeten Vorrichtungen weisen insofern Nachteile auf, dass der Reaktorschuss immer beim Ausbau weggehoben werden muss, so dass die Stabpaare zumindest zeitweise frei und ohne Umfallschutz auf der Bodenplatte stehen. Dies weist ein erhebliches Sicherheitsrisiko auf, denn umfallende Stäbe oder Teile von Stäben können neben oder an der Abscheideanlage arbeitende Mitarbeiter erheblich verletzten. Sollte der Ausbau über einen zusätzlichen oberen Flansch im Reaktor erfolgen, dann besteht der Nachteil, dass die Glockenreinigung der entsprechenden Abscheideanlage erst dann erfolgen kann, wenn der Ausbau der Stäbe abgeschlossen ist. Bei diesem Vorgehen ist die benötigte Zeit für den Chargenwechsel (abscheidungsfreie Zeit) deutlich höher, als wenn die Glocke gleich gereinigt werden könnte und nach dem Ausbau nicht noch auf die erfolgte Reinigung gewartet werden müsste.

Die Aufgabe der vorliegenden Erfindung bestand darin, ein Verfahren zur chargenweisen Herstellung von hochreinem polykristallinen Silicium mit möglichst geringen Chargenwechselzeiten der einzelnen Anlagen auch im Anlagenverbund bereitzustellen, welches die Nachteile des Stands der Technik vermeidet oder überwindet.

Die Aufgabe wird gelöst durch ein Verfahren zur Herstellung von polykristallinem Silicium nach Anspruch 1.

Während der Abscheidung ist der Reaktor üblicherweise luftdicht verschlossen.

Beim Trägerkörper handelt es sich üblicherweise um einen U-förmigen Trägerkörper umfassend zwei Siliciumstäbe und eine waagerechte Brücke. Während der Abscheidung wächst der Durchmesser des Trägerkörpers an. Somit entsteht bei der Abscheidung von polykristallinem Silicium auf dem Trägerkörper ein Siliciumstabpaar.

Die Reaktionsgase, nämlich die Silicium enthaltende Komponente, bei dem es sich beispielsweise um ein Chlorsilan wie Trichlorsilan handelt, und Wasserstoff, werden über eine Zuführleitung in den Reaktor eingeleitet.

Bei der Abscheidung entsteht ein Abgas enthaltend u.a. Siliciumtetrachlorid, das über eine Abführleitung aus dem Reaktor entfernt wird.

Sobald der gewünschte Enddurchmesser der Siliciumstabpaare erreicht ist, wird die Abscheidung üblicherweise beendet, nämlich dadurch, dass die Stromversorgung beendet und die Zufuhr von Reaktionsgasen gestoppt wird. Zu diesem Zweck sind üblicherweise Absperrventile in der Zuführleitung für Reaktionsgase vorhanden.

Bevor der Ausbau der Stäbe beginnt, werden zunächst Anschlüsse von einem Reaktoroberteil des Reaktors entfernt.

nach Entfernung der Anschlüsse vom Reaktoroberteil wird eine Schutzhülle um den Abscheidereaktor herum angebracht. Anschließend wird das Reaktoroberteil entfernt, insbesondere durch Hochheben des Reaktoroberteils.

In einer zweiten bevorzugten Ausführungsform ist vorgesehen, Schutzelemente am Reaktoroberteil anzubringen. Diese Schutzelemente werden beim Hochheben des Reaktoroberteils nach dessen Lösen vom Bodenaufbau mit nach oben gezogen. Die Schutzelemente sind derart gestaltet, dass sie nach einem gewissen Hochheben des Reaktoroberteils die polykristallinen Siliciumstabpaare vollständig umgeben. Sobald dies der Fall ist, werden die Schutzelemente mit dem Bodenaufbau, nämlich der Bodenplatte des Reaktors, verbunden und vom Reaktoroberteil gelöst. Die Schutzelemente bilden die Schutzwand, die im erfindungsgemäßen Verfahren vorgesehen ist.

In einer weiteren bevorzugten Ausführungsform ist eine fahrbare und klappbare Schutzhülle oder Schutzwand vorgesehen, die seitlich an den Reaktor herangefahren werden kann und Klapptüren enthält.

Das Verfahren und dessen bevorzugte Ausführungsform haben den Vorteil, dass die Stäbe zu keinem Zeitpunkt frei und ungeschützt der Umgebung in der Abscheidehalle ausgesetzt sind.

Vorzugsweise wird nach Beendigung der Abscheidung der Reaktor für einen bestimmten Zeitraum geöffnet, bevor oder während die Anschlüsse vom Reaktoroberteil entfernt werden. Dieser Zeitraum des Lüftens beginnt vorzugsweise mit der ersten Öffnung des Reaktors nach dem Abscheiden einer Charge polykristallinen Siliciums und umfasst den Zeitraum nach Beendigung der Abscheidung bis zum Entfernen der Glocke oder Teile derselben mit dem Zweck, einen polykristallinen Siliciumstab aus dem Reaktor auszubauen. Auch beim Stabausbau selbst ist der Reaktor geöffnet, wird dabei belüftet oder mit einem Spülgas gespült. Das Belüften kann durch Anheben der Reaktorglocke über die Bodenplatte erfolgen.
Ebenso kann ein Schauglas geöffnet werden.
Auch ein Öffnen von Flanschen, Zugas-, Abgasleitungen dient dem Belüften des Reaktors.
Während des Öffnens des Reaktors kann ein Medium über eine Öffnung in den Reaktor zugeführt und dann über dieselbe oder eine andere Öffnung wieder abgeführt werden.
Beim zugeführten Medium kann es sich um Luft oder deren Einzelbestandteile, Stickstoff, Feuchte, Argon, Helium jeweils einzeln oder in Kombination handeln.

Dies dient dazu, ab dem Erreichen des gewünschten Zieldurchmessers des Trägerkörpers und Beendigung der Abscheidung, den Reaktorinnenraum mit enthaltenen gasförmigen flüssigen und/oder festen Bestandteilen sowie den darin enthaltene Glockenbelag unter definierten Bedingungen vor vollständigem Öffnen des Abscheidereaktors zum Zwecke des Stabausbaus in geeigneter Weise zu konditionieren.

Vorzugsweise werden die Stabpaare vor deren Ausbau und sobald sie zugänglich sind mit einem Überzug versehen. Dabei kann es sich um einen Sack aus Kunststoff handeln, der die Stabpaare umschließt. Vorzugweise handelt es sich um ein sackartiges Teil aus hochreinem PE.

Der Ausbau der Stabpaare erfolgt vorzugsweise mit einer Vorrichtung, die so dimensioniert ist, dass sie ein U-förmiges Stabpaar vollständig umschließen kann, wobei die Vorrichtung mit dem von ihm umschlossenen U-förmigen Stabpaar derart mit einem Kran, einem Seilzug oder einem Greifer zusammenwirkt, dass die Vorrichtung mitsamt dem U-förmigen Stabpaar aus dem Reaktor entfernt werden kann.

Die Vorrichtung kann aus einem kontaminationsarmen Hartmetall oder aus einem Kunststoff gefertigt sein. Sie kann bevorzugt aus Stahl bestehen besonders bevorzugt aus Edelstahl wie V2A = 1.4301, 1.4541 und 1.4307 oder Kombinationen dieser Werkstoffe, wobei die Innenwand mit einem kontaminationsarmen Material, z.B. einem Kunststoff oder einem Hartmetall, beschichtet oder ausgekleidet sein kann. Ein Aufbringen von einer oder mehreren Schichten Gold oder Silber auf die innere Oberfläche der Vorrichtung kann erfolgen. Dabei kann diese Aufbringung chemisch oder mechanisch erfolgen (z. B. als Composit oder Plattierung (Sphäroguss mit Hartmetallkörnchen oder Plättchen)).

Nach dem Ausbau der Stäbe werden diese vorzugweise zur Weiterverarbeitung abtransportiert.

Die Trägerkörper werden durch direkten Stromdurchgang auf eine Temperatur erhitzt, bei der sich polykristallines Silicium auf diesen abscheidet. Die Stabtemperatur beträgt vorzugsweise 1150 K bis 1600 K. Die Trägerkörper sind zu diesem Zweck üblicherweise mit Elektroden aus hochreinem Elektrographit verbunden, über die die Stromversorgung erfolgt. Vorzugweise wird daher nach dem Ausbau der Stabpaare die Graphitelektrode vom Stabfuß entfernt.

Anschließend werden die Stabpaare vorzugweise zu Bruchstücken unterschiedlicher Größenklassen zerkleinert, z.B. mittels eines Backen- oder eines Walzenbrechers.

Nach der Zerkleinerung erfolgt ggf. eine nasschemische Reinigung der Bruchstücke.

Schließlich werden die Bruchstücke vorzugsweise in Kunststoffbeutel verpackt und zu den Kunden transportiert.

Im Folgenden werden bevorzugte Ausführungsformen der Erfindung dargestellt.

Wie bereits erwähnt, wird im Stand der Technik das Reaktoroberteil entfernt, wobei zuvor alle an das Reaktoroberteil angeschlossenen Bauteile entfernt werden. Die Entfernung des Reaktoroberteils erfolgt üblicherweise durch Hochfahren desselben. Nach Entfernen des Reaktoroberteils können die frei stehenden Stabpaare ausgebaut werden. Es besteht jedoch die Gefahr, dass die Stabpaare umfallen können. Zudem sind die Stabpaare der Umgebung und damit ggf. Kontaminationseinflüssen ausgesetzt.

Die Erfindung beschreibt ein Verfahren, durch das die Rüstzeiten eines CVD Reaktors ohne Einbußen von Sicherheitsaspekten deutlich reduziert werden können.

Die Erfindung wird nachfolgend auch anhand der **Fig. 1 -3** erläutert.

### Kurzbeschreibung der Figuren

- **Fig. 1**: zeigt einen Reaktor mit Schutzhülle.
- **Fig. 2**: zeigt einen Reaktor mit Schutzelementen.
- **Fig. 3**: zeigt einen Reaktor und eine fahrbare Schutzwand.

### Liste der verwendeten Bezugszeichen

- **1**: Reaktoroberteil (Glocke)
- **2**: Schutzhülle
- **3**: Medien Zu- bzw. Abführung
- **4**: Medien Zu- bzw. Abführung
- **5**: Polykristalline Siliciumstäbe
- **6**: Bodenaufbau / Bodenplatte
- **7**: Schutzelemente
- **8**: Fahrbare Schutzwand

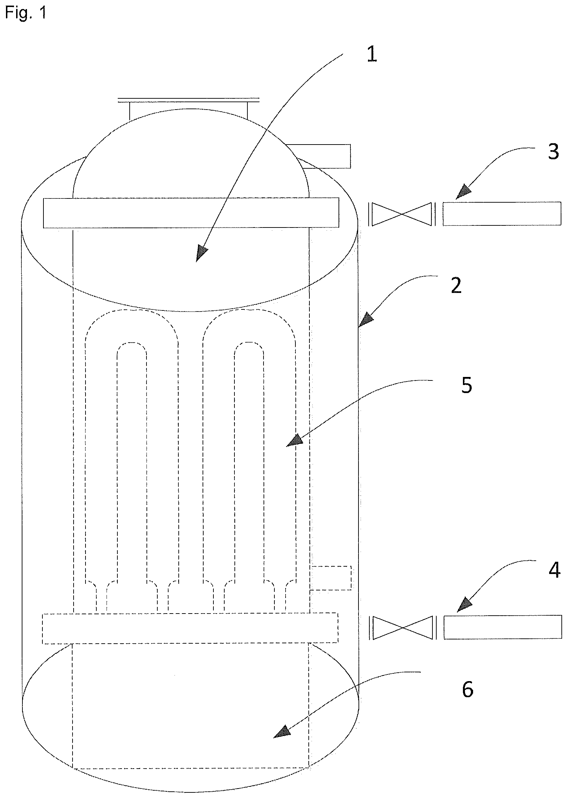

In **Fig. 1** ist eine erste Ausführungsform des Verfahrens dargestellt.

Sie zeigt einen Reaktor mit einem Reaktoroberteil 1, Zu- und Abführungen 3 und 4 für Medien (Reaktionsgase, Abgas), einem Bodenaufbau 6 (insb. Bodenplatte mit Elektroden) und den U-förmigen polykristallinen Siliciumstabpaaren 5. Der Reaktor ist von einer Schutzhülle 2 umgeben.

Zum Ausbau der polykristallinen Siliciumstabpaare 5 werden zunächst alle am Reaktoroberteil 1 angeschlossenen Bauteile entfernt. Dabei handelt es sich insbesondere um die Anschlüsse der Zu- und Abführungen 3 und 4 für Medien. Anschließend wird die Schutzhülle 2 über den gesamten Reaktor, also über Reaktoroberteil 1 und Bodenaufbau 6 gestülpt. Dann wird das Reaktoroberteil 1 vom Bodenaufbau 6 gelöst, hochgefahren und zur Reinigung abtransportiert.

Durch die Schutzhülle 2 wird sichergestellt, dass Mitarbeiter vor eventuell umfallenden polykristallinen Siliciumstabpaaren 5 geschützt sind. Zudem können die polykristallinen Siliciumstabpaare 5 trotz fehlenden Reaktoroberteiles 1 sicher ausgebaut werden. Der Ausbau der polykristallinen Siliciumstabpaare 5 selbst kann mittels Greifern, Kränen oder Ausbaukörben wie im Stand der Technik beschrieben erfolgen.

Durch den Produktionsprozess bedingt, sollten vor der Neubestückung des Reaktors alle Oberflächen des Reaktors gereinigt werden. Die Reinigung der Reaktorinnenwände konnte jedoch bislang erst dann erfolgen, wenn die polykristallinen Siliciumstabpaare 5 aus dem Reaktor entfernt wurden.

Durch die vorliegende Erfindung kann jedoch am Reaktoroberteil 1 sofort nach dem Lösen vom Bodenaufbau 6 mit der Reinigung begonnen werden.

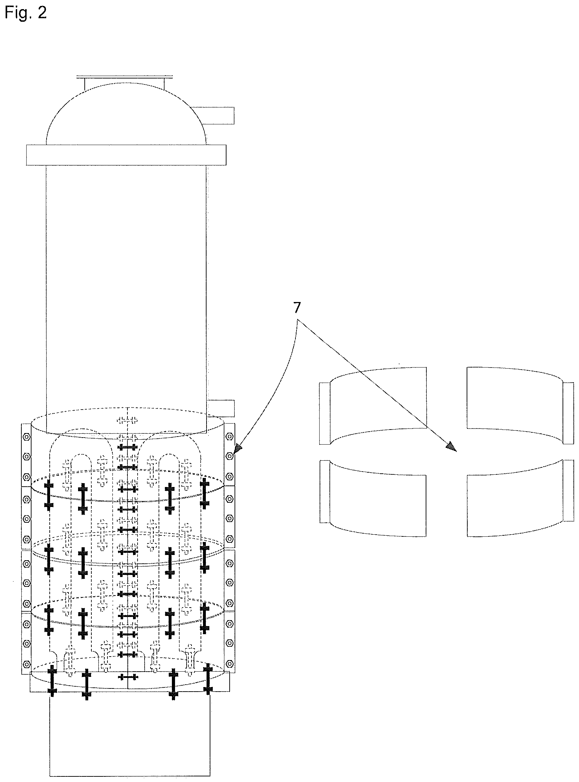

In **Fig. 2** ist eine weitere Ausführungsform des erfindungsgemäßen Verfahrens dargestellt.

Diese Ausführungsform sieht quasi einen mitwachsenden Ausbauschutz vor. Statt einer Schutzhülle wie in Fig. 1 beschrieben, die über den gesamten Reaktor gestülpt wird, sind Schutzelemente 7 vorgesehen, die am Reaktoroberteil angebracht sind. Diese Schutzelemente werden beim Hochheben des Reaktoroberteils nach dessen Lösen vom Bodenaufbau mit nach oben gezogen. Die Schutzelemente 7 sind derart gestaltet, dass sie nach einem gewissen Hochheben des Reaktoroberteils die polykristallinen Siliciumstabpaare 5 vollständig umgeben. Sobald dies der Fall ist, werden die Schutzelemente 7 mit dem Bodenaufbau verbunden und vom Reaktoroberteil gelöst. Auch in dieser Ausführungsform kann unmittelbar mit der Reinigung des Reaktoroberteils begonnen werden.

Vorzugsweise wird zunächst das Reaktoroberteil angehoben und die Schutzelemente 7 montiert. Anschließend werden die Schutzelemente 7 mit dem Bodenaufbau verbunden, wobei die Verbindung von Schutzelementen 7 und Reaktoroberteil gelöst wird. Schließlich wird das Reaktoroberteil zur Reinigung abtransportiert.

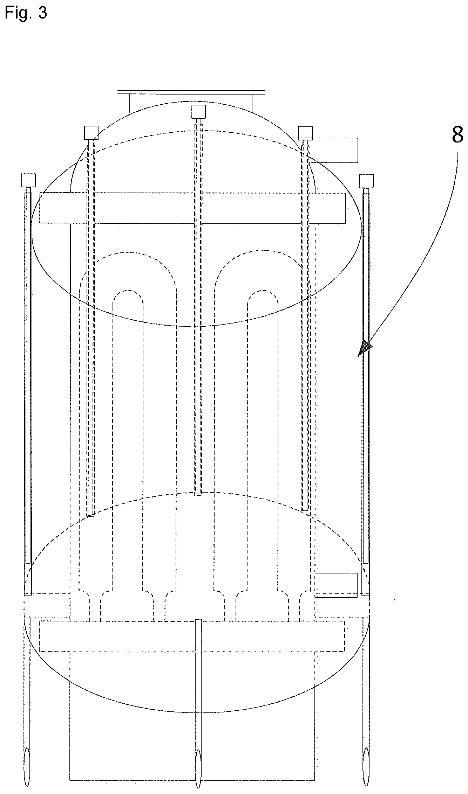

In **Fig. 3** ist eine weitere Ausführungsform des erfindungsgemäßen Verfahrens dargestellt.

Hier handelt es sich um eine Art fahrbare und klappbare Schutzhülle oder Schutzwand 8. Fahrbar deshalb, da sie seitlich an den Reaktor herangefahren werden kann. Klappbar deshalb, da sie Klapptüren umfasst.

Die Schutzwand 8 wird von der Seite an den Reaktor herangefahren. Über Klapptüren wird der Reaktor umschlossen, die Klapptüren werden verschlossen, z.B. mittels Bolzen verriegelt.

## Patentansprüche

1. Verfahren zur Herstellung von polykristallinem Silicium, umfassend Einleiten eines Reaktionsgases enthaltend eine Silicium enthaltende Komponente und Wasserstoff in einen Reaktor enthaltend eine Bodenplatte, ein auf der Bodenplatte befestigtes Reaktoroberteil und wenigstens einen durch direkten Stromdurchgang erhitzten Trägerkörper, auf dem polykristallines Silicium abgeschieden wird, so dass wenigstens ein polykristalliner Siliciumstab erhalten wird, **dadurch gekennzeichnet, dass** nach Beendigung der Abscheidung während des Ausbaus des wenigstens einen polykristallinen Siliciumstabs aus dem Reaktor eine Schutzhülle oder Schutzwand um den Reaktor herum angebracht ist, wobei nach Beendigung der Abscheidung Anschlüsse am Reaktoroberteil entfernt werden, die Schutzhülle oder Schutzwand seitlich um den Abscheidereaktor herum angebracht und das Reaktoroberteil anschließend entfernt wird, um den wenigstens einen polykristallinen Siliciumstab auszubauen.

2. Verfahren zur Herstellung von polykristallinem Silicium gemäß Anspruch 1, **dadurch gekennzeichnet, dass** die Schutzhülle nach dem Entfernen aller Anschlüsse am Reaktoroberteil über das Reaktoroberteil und die Bodenplatte gestülpt wird.

3. Verfahren zur Herstellung von polykristallinem Silicium gemäß Anspruch 1, **dadurch gekennzeichnet, dass** die Schutzwand aus Schutzelementen gebildet wird, wobei die Schutzelemente seitlich am Reaktoroberteil angebracht werden, dann das Reaktoroberteil zusammen mit den Schutzelementen vertikal nach oben bewegt wird, bis der wenigstens eine polykristalline Siliciumstab vollständig von den Schutzelementen umgeben ist, anschließend die Schutzelemente mit der Bodenplatte verbunden und die Befestigung der Schutzelemente am Reaktoroberteil gelöst wird.

4. Verfahren zur Herstellung von polykristallinem Silicium gemäß Anspruch 1, **dadurch gekennzeichnet, dass** es sich bei der Schutzwand um eine fahrbare und klappbare Schutzwand enthaltend Klapptüren handelt, die seitlich an den Reaktor herangefahren wird, wobei der Reaktor von der Schutzwand vollständig umschlossen wird und die Klapptüren verschlossen werden, bevor mit der Entfernung des Reaktoroberteils und dem Ausbau des wenigstens einen polykristallinen Siliciumstabs begonnen wird.

5. Verfahren nach einem der Ansprüche 1 bis 4, wobei nach Beendigung der Abscheidung der Reaktor für einen bestimmten Zeitraum geöffnet wird, bevor oder während Anschlüsse vom Reaktoroberteil entfernt werden und bevor die Schutzhülle oder Schutzwand angebracht oder an den Reaktor herangefahren wird.

6. Verfahren nach einem der Ansprüche 1 bis 5, wobei vor dem Ausbau des wenigstens einen polykristallinen Siliciumstabs dieser mit einem sackartigen Teil aus Kunststoff überzogen wird.

7. Verfahren nach einem der Ansprüche 1 bis 6, wobei der wenigstens eine Trägerkörper zwei Siliciumstäbe umfasst, die über eine waagerechte Brücke miteinander verbunden sind, so dass wenigstens ein polykristallines Siliciumstabpaar abgeschieden wird.

8. Verfahren nach Anspruch 7, wobei zum Ausbau des wenigstens einen polykristallinen Siliciumstabpaars eine Vorrichtung verwendet wird, die so dimensioniert ist, dass sie das polykristalline Siliciumstabpaar vollständig umschließen kann, wobei die Vorrichtung mit dem von ihm umschlossenen polykristallinen Siliciumstabpaar derart mit einem Kran, einem Seilzug oder einem Greifer zusammenwirkt, dass die Vorrichtung mitsamt dem polykristallinen Siliciumstabpaar aus dem Reaktor entfernt werden kann.

9. Verfahren nach einem der Ansprüche 1 bis 8, wobei der wenigstens eine polykristalline Siliciumstab ausgebaut und mechanisch bearbeitet wird, um Bruchstücke aus polykristallinem Silicium zu erhalten.

## Claims

1. Process for producing polycrystalline silicon, comprising introducing a reaction gas comprising a silicon-containing component and hydrogen into a reactor comprising a base plate, an upper reactor section secured to the base plate and at least one support body heated by direct passage of current, on which polycrystalline silicon is deposited, such that at least one polycrystalline silicon rod is obtained, **characterized in that**, after the deposition has ended, a protective shell or protective wall is placed around the reactor during the deinstallation of the at least one polycrystalline silicon rod from the reactors, wherein, after the deposition has ended, connections on the upper reactor section are removed, the protective shell or protective wall is placed laterally around the deposition reactor and the upper reactor section is subsequently removed, in order to deinstall the at least one polycrystalline silicon rod.

2. Process for producing polycrystalline silicon according to Claim 1, **characterized in that** the protective shell, after the removing of all connections on the upper reactor section, is placed over the upper reactor section and the base plate.

3. Process for producing polycrystalline silicon according to Claim 1, **characterized in that** the protective wall is formed from protective elements, wherein the protective elements are placed laterally on the upper reactor section, then the upper reactor section together with the protective elements is moved vertically upward until the at least one polycrystalline silicon rod is completely surrounded by the protective elements, then the protective elements are connected to the base plate and the securing of the protective elements to the upper reactor section is released.

4. Process for producing polycrystalline silicon according to Claim 1, **characterized in that** the protective wall is a movable and foldable protective wall comprising folding doors, which is moved onto the side of the reactor, wherein the reactor is completely surrounded by the protective wall and the folding doors are closed before the removal of the upper reactor section and the deinstallation of the at least one polycrystalline silicon rod is commenced.

5. Process according to any of Claims 1 to 4, wherein, after the deposition has ended, the reactor is opened for a particular period before or while connections are being removed from the upper reactor section and before the protective shell or protective wall is placed or moved onto the reactor.

6. Process according to any of Claims 1 to 5, wherein, prior to the deinstallation of the at least one polycrystalline silicon rod, the latter is covered with a bag-like plastic component.

7. Process according to any of Claims 1 to 6, wherein the at least one support body comprises two silicon rods connected to one another via a horizontal bridge, such that at least one polycrystalline silicon rod pair is deposited.

8. Process according to Claim 7, wherein deinstallation of the at least one polycrystalline silicon rod pair is accomplished using an apparatus having such dimensions that it can completely surround the polycrystalline silicon rod pair, wherein the apparatus together with the polycrystalline silicon rod pair that it surrounds interacts with a crane, a cable winch or a grab such that the apparatus along with the polycrystalline silicon rod pair can be removed from the reactor.

9. Process according to any of Claims 1 to 8, wherein the at least one polycrystalline silicon rod is deinstalled and mechanically processed to obtain chunks of polycrystalline silicon.

## Revendications

1. Procédé pour la préparation de silicium polycristallin, comprenant l'introduction d'un gaz de réaction contenant un composant contenant du silicium et de l'hydrogène dans un réacteur contenant une plaque de fond, une partie supérieure du réacteur fixée sur la plaque de fond et au moins un corps support chauffé par un passage direct de courant, sur lequel le silicium polycristallin est déposé, de telle sorte qu'au moins une tige de silicium polycristallin est obtenue, **caractérisé en ce qu'**après la fin du dépôt, pendant le démontage de ladite au moins une tige de silicium polycristallin du réacteur, une enveloppe ou une paroi de protection est appliquée autour du réacteur, des raccords au niveau de la partie supérieure du réacteur étant enlevés après la fin du dépôt, l'enveloppe ou la paroi de protection étant appliquée latéralement autour du réacteur de dépôt et la partie supérieure du réacteur étant ensuite enlevée pour démonter ladite au moins une tige de silicium polycristallin.

2. Procédé pour la préparation de silicium polycristallin selon la revendication 1, **caractérisé en ce que** l'enveloppe de protection est enfilée sur la partie supérieure du réacteur et la plaque de fond après l'enlèvement de tous les raccords au niveau de la partie supérieure du réacteur.

3. Procédé pour la préparation de silicium polycristallin selon la revendication 1, **caractérisé en ce que** la paroi de protection est formée à partir d'éléments de protection, les éléments de protection étant appliqués latéralement sur la partie supérieure du réacteur, la partie supérieure du réacteur étant ensuite déplacée conjointement avec les éléments de protection verticalement vers le haut, jusqu'à ce que ladite au moins une tige de silicium polycristallin soit complètement entourée par les éléments de protection, ensuite, les éléments de protection sont reliés à la plaque de fond et la fixation des éléments de protection à la partie supérieure du réacteur est défaite.

4. Procédé pour la préparation de silicium polycristallin selon la revendication 1, **caractérisé en ce qu'**il s'agit, pour la paroi de protection, d'une paroi de protection mobile et pliable contenant des portes à trappe, qui est déplacée latéralement contre le réacteur, le réacteur étant entouré complètement par la paroi de protection et les portes à trappe étant fermées avant de commencer l'enlèvement de la partie supérieure du réacteur et le démontage de ladite au moins une tige de silicium polycristallin.

5. Procédé selon l'une quelconque des revendications 1 à 4, le réacteur étant ouvert pour une période de temps déterminée après la fin du dépôt, avant ou pendant l'enlèvement des raccords de la partie supérieure du réacteur et avant l'application de l'enveloppe ou de la paroi de protection ou leur déplacement contre le réacteur.

6. Procédé selon l'une quelconque des revendications 1 à 5, ladite au moins une tige de silicium polycristallin étant revêtue par une pièce de type sac en matériau synthétique avant le démontage de celle-ci.

7. Procédé selon l'une quelconque des revendications 1 à 6, ledit au moins un corps support comprenant deux tiges de silicium, qui sont reliées l'une à l'autre via un pont horizontal de telle sorte qu'au moins une paire de tiges de silicium polycristallin est déposée.

8. Procédé selon la revendication 7, un dispositif étant utilisé pour le démontage de ladite au moins une paire de tiges de silicium polycristallin, qui est dimensionné de manière telle qu'il peut entourer complètement la paire de tiges de silicium polycristallin, le dispositif, comprenant la paire de tiges de silicium polycristallin entourée par celui-ci, interagissant avec une grue, un câble ou un grappin de manière telle que le dispositif peut être enlevé du réacteur ensemble avec la paire de tiges de silicium polycristallin.

9. Procédé selon l'une quelconque des revendications 1 à 8, ladite au moins une tige de silicium polycristallin étant démontée et usinée mécaniquement pour obtenir des fragments de silicium polycristallin.
